# EUROPÄISCHE PATENTANMELDUNG

(11) **EP 2 293 358 A1**
(43) Veröffentlichungstag der Anmeldung: **09.03.2011**
(21) Anmeldenummer: 09010962.0
(22) Anmeldetag: 27.08.2009
(51) Int. Cl.: H01L 51/50, H01L 51/52

(54) **Elektrolumineszenzlampe mit Kontaktmittel**

(71) Anmelder: Bayer MaterialScience AG, 51368 Leverkusen (DE)
(72) Erfinder: Degiorgio, Nicolas, 47800 Krefeld (DE); Knippenberg, Dirk, 51789 Lindlar (DE); Wagner, Thomas, 63594 Hasselroth (DE)

(57) **Zusammenfassung**

Bei der erfindungsgemäßen Elektrolumineszenzlampe mit einer zwischen einer ersten und einer zweiten transluzenten oder klarsichtigen Kunststoffplatte einlaminierten EL-Folie sind die Kontaktflächen und Federkontakte innerhalb des Bereichs der Kunststoffplatten, und nicht wie beim Stand er Technik an deren Außenseite vorgesehen. Es besteht mehr Gestaltungsspielraum und vorteilhafte Optik für in Gestalt eines Design- oder Gebrauchsobjekts gestaltete Elektrolumineszenzlampen. Das Kontaktmittel, beispielsweise ein Stecker, wird nicht von der Seite mit den Kontakten verbunden, sondem wird von oben auf die Fläche aufgesetzt. Die Kontaktflächen liegen in der Ausnehmung frei und können von oben her mit den senkrecht zur Kunststoffplatte fedemd ausgestalteten Federkontakten elektrisch leitend verbunden werden.

## Beschreibung

Die Erfindung betrifft eine in Gestalt eines Design- oder Gebrauchsobjekts ausgeführte Elektrolumineszenzlampe, wie zum Beispiel als Stuhl, Tisch, Liege oder Möbel. Insbesondere betrifft die Erfindung eine Elektrolumineszenz-Lampe in Gestalt eines Design- oder Gebrauchsobjekts, mit einer zwischen einer ersten und einer zweiten transluzenten oder klarsichtigen Kunststoffplatte einlaminierten EL-Folie, wobei die EL Folie mehrere elektrisch leitfähige nicht mit einer isolierenden Schicht versehene Kontaktflächen aufweist, die sich in der Ebene der EL-Folie erstrecken und die senkrecht zur Ebene der EL Folie kontaktierbar sind und einem Kontaktmittel mit Federkontakten zur elektrischen Verbindung der Kontaktflächen mit einer Spannungsversorgung.

Elektrolumineszenzfolien, im Folgenden EL-Folien genannt, sind eine technische Anwendung der Elektrolumineszenzumwandlung elektrischer Energie in Licht. Eine EL-Folie ähnelt einem Plattenkondensator und weist mindestens zwei leitende Schichten (Elektroden) auf, die zumindest an einer Stelle elektrisch kontaktierbar sein müssen. Zu diesem Zweck kann beispielsweise an der zur Kontaktierung vorgesehenen Stelle der Folie beabsichtigt keine elektrische Isolierung aufgetragen sein. Alternativ wird die EL-Folie aus dem vorgesehenen Leuchtbereich heraus über einen schmalen Streifen geführt, an dessen Ende die Elektroden freigelegt sind.

Produkte mit EL-Folien müssen betriebssicher ausgelegt sein, das heißt, die empfindlichen Flächen müssen gegen Beschädigung, Knickung, Feuchtigkeit und Kurzschluss geschützt werden. Der Verwender muss gegen elektrischen Schlag geschützt werden. Zu diesem Zweck ist das Einlaminieren der EL-Folie zwischen Kunststoffflächen üblich, wobei zumindest die vordere Folie transluzent oder klarsichtig sein muss. Das Laminat kann dabei beispielsweise flexibel und biegbar sein. Das Laminat kann in einem weiteren Arbeitsschritt auf einen festen Träger aufgebracht werden. Es wären ebenfalls Laminate denkbar, die eigenstabil und tragend sind, wie zum Beispiel eine zwischen zwei dicken Kunststoffplatten einlaminierte EL-Folie bestehen.

Daraus ließen sich Objekte schaffen, deren gesamte Flächen oder Teilflächen aus gebogenen Kunststoffplatten bestehen, beispielsweise Tische, Stühle, Liegen oder Möbel bzw. Teile davon, wie zum Beispiel eine Schranktür oder Tür. Bedingt durch die bandartige und flexible Ausgestaltung einer EL-Folie, sowie der oben beschriebenen Anordnung der Elektroden, werden EL-Folien bzw. mit EL-Folien ausgestattete Produkte bislang mittels eines von der Seite her aufgesteckten Steckers kontaktiert. Die EL-Folie ist seitlich aus dem Laminat herausgeführt und steht daher über die Kante des Objekts heraus. Die überstehende Folie muss kontaktiert werden, so dass weitere optisch störende Bauteile notwendig sind.

Ferner sind zwischen flexiblen oder festen Folien bzw. Platten einlaminierte EL-Folien bekannt, bei denen die Folien bzw. Platten von der Seite her eine Ausnehmung aufweisen, durch die die Kontaktzonen der EL-Folie freigelegt werden. Zum Kontaktieren wird dabei ein Stecker in oder auf die Seitenkante aufgeschoben. Je nach Ausgestaltung des Gebildes ergeben sich durch den seitlich aufgesteckten Stecker Nachteile in Bezug auf Optik, Betriebssicherheit und Handhabbarkeit. Zusätzlich kommt es in dem Weiterverarbeitungsprozess beim Laminieren zu Komplikationen, die nicht kostengünstig im Rahmen einer Serienfertigung auszuräumen sind.

Als Kontaktmittel für den freigelegten Kontakt einer EL-Folie sind auf die Folienkante aufsetzbare Stecker mit senkrecht zur Folienoberfläche federnd wirkenden Federkontakten bekannt, die beim Aufschieben auf die Folie federnd nachgeben und dabei den elektrischen Kontakt herstellen.

Demzufolge ist es Aufgabe der vorliegenden Erfindung, ein verbessertes Design oder Gebrauchsobjekt mit zwischen zwei Kunststoffplatten einlaminierten EL-Folien zu schaffen.

Diese Aufgabe wird gelöst durch ein Objekt mit den Merkmalen des Hauptanspruchs. Vorteilhafte Ausgestaltungen sind Gegenstand der Unteransprüche.

Erfmdungsgemäß wurde erkannt, dass bei einer gattungsgemäßen Elektrolumineszenzlampe das Vorsehen von Kontaktflächen und Federkontakten innerhalb des Bereichs der Kunststoffplatten, und nicht wie beim Stand er Technik an deren Außenseite, mehr Gestaltungsspielraum und vorteilhafte Optik für in Gestalt eines Design- oder Gebrauchsobjekts gestaltete Elektrolumineszenzlampen besteht. Also wird das Kontaktmittel, beispielsweise ein Stecker, nicht von der Seite mit den Kontakten verbunden, sondern wird von oben auf die Fläche aufgesetzt. Die Kontaktflächen befinden sich also nicht an oder in der Seitenkante der Kunststoffplatten, sondern innerhalb des Bereichs der Kunststoffplatten. Sofern in der Kunststoffplatte eine Ausnehmung notwendig wird, liegt diese, anders als beim Stand der Technik nicht am Rand, sondern in der Platte. Die Ausnehmung ist also zu allen vier Seiten von der Kunststoffplatte umgeben. Daher sind die Kontaktflächen nur von oben her zugänglich und kontaktierbar.

Die Kontaktflächen liegen in der Ausnehmung frei und können von oben her mit den senkrecht zur Kunststoffplatte federnd ausgestalteten Federkontakten elektrisch leitend verbunden werden, wenn das Kontaktmittel gegen die Platte geführt wird. Zur dauerhaften Fixierung der Kontaktmittel und der gegen die Kontaktflächen abgestützten Federkontakte sind in der ersten Kunststoffplatte Befestigungsmittel zum Befestigen der Kontaktmittel mit dieser vorgesehen. Darunter fallen die dem Fachmann geläufigen Maßnahmen, wie zum Beispiel Einrastverbindungen, Verklebungen, Verschraubungen etc., wobei die Befestigungsmittel auf oder in der Oberfläche der Kunststoffplatte, beispielsweise in Form von Gewinden oder mittels Klebers oder darin eingebrachten Gewindehülsen oder auch an der Innenwand der Ausnehmung, beispielsweise in Form von Hinterschneidungen, Rillen etc. vorgesehen sein können.

Vorzugsweise ist eine Vielzahl von Kontaktflächen vorgesehen, die in einer gemeinsamen Ausnehmung frei liegen. Eine Ausnehmung wird also für eine Vielzahl von Kontaktflächen genutzt, so dass der Herstell- und Bearbeitungsaufwand reduziert wird. Mit dem Befestigen eines Kontaktmittels können daher gleichzeitig eine Vielzahl von Kontakten geschlossen werden, was insbesondere dann von Vorteil ist, wenn eine Vielzahl von elektrischen Kreisen, beispielsweise farblich und/oder räumlich unterschiedliche EL-Folien zum Einsatz kommen, was vorzugsweise über eine Mehrsegmentfolie mit einer entsprechenden Vielzahl von Kontaktflächen realisiert sein kann. Jeder zusätzliche Kontakt erlaubt das Ansteuern der Beleuchtung eines weiteren Gebietes bzw. Segmentes oder Farbe.

Prinzipiell kann die Erfmdung dadurch ausgeführt werden, dass zu beiden Seiten des Kunststoffplattenlaminats Kontaktflächen und entsprechende Kontaktmittel angebracht werden. Dieses kann beispielsweise dann zweckmäßig sein, wenn unabhängig voneinander das Kunststoffplattenlaminat zu beiden Seiten leuchten soll. In gestalterischer Hinsicht ist jedoch das Vorsehen der Kontaktflächen auf nur einer Seite, vorzugsweise der nichtleuchtenden Rückseite der EL-Folie zu bevorzugen.

Der kompakte Stecker, welcher die Federkontakte und Befestigungselemente aufweist, muss zwingend lediglich den Kontakt herstellen. In diesem Fall kann der Stecker besonders flach ausgestaltet sein und somit gegebenenfalls sogar unauffällig vollkommen in die Ausnehmung eingesetzt werden. Der Stecker ist daher weitgehend miniaturisierbar und unauffällig und dient dabei lediglich der Zuführung des Stromkabels, welches vom Inverter/der Ansteuerung zugeführt wird.

Alternativ kann der Stecker als kompakte Einheit mit der notwendigen Ansteuerung inklusive Inverter ausgebildet sein. Von diesem führt dann lediglich ein Stromkabel zum Stromnetz. Für den Benutzer ergibt sich eine besonders anwenderfreundliche und unauffällige Verbindung mit dem Stromnetz ohne aufwändige Netzteile/Inverteransteuerung. Vorzugsweise kann die Ansteuerung dabei über eine Fernbedienung erfolgen, das heißt die Ansteuerung der kompakte Stecker weist einen Fernsteuerempfänger auf, dessen Technik auf bekannten Verfahren besteht, beispielsweise elektromagnetische oder optische Kommandos, insbesondere Infrarot, W-LAN und/oder Bluetooth. Die erfindungsgemäße Lösung erlaubt die serienfähige kostengünstige flächige Kontaktierung von in Kunststoff einlaminierten EL-Folien. Die Erfmdung ist sowohl von Mehrsegment- als auch Einzelsegmentlampen anwendbar. Erfindungsgemäß wird also eine Lösung geschaffen, bei der eine flächige Kontaktierung nach dem Laminieren der Folie möglich ist. Wenn es sich um entsprechend dicke Kunststoffplatten als Laminat handelt, wird die sich im Bereich der Ausnehmung ergebene Stufe zwischen den Kontakten der EL-Folie und der Kunststoffoberfläche überbrückt werden. Die Federelemente erlauben dabei eine sichere Kontaktierung, die auch bei Erschütterungen bzw. elastischer Verformung des aus dem Kunststofflaminat gebildeten Gegenstandes ausreichend sicher ist. Die aus dem Stand der Technik weiteren bekannten Kontaktiermöglichkeiten, wie zum Beispiel das Verkabeln, das Crimpen oder das Kontaktieren mittels Flexen oder Zweikomponentenkleber sind nicht geeignet, da diese Maßnahmen vor dem Laminierprozess durchgeführt werden müssen und beim Laminierprozess einlaminiert würden und somit nicht mehr einsatzfähig sind.

Die anspruchsgemäß angegebenen Wandstärken/Dicken der Kunststoffplatten, beispielsweise Plexiglasplatten, sind derartig gewählt, dass allerseits eine ausreichende Eigenstabilität des daraus geformten Gegenstandes gegeben ist, damit Möbel und dergleichen geformt werden können. Andererseits ist die Wandstärke derart ausgewählt, dass die notwendige Warmverformung mit einlaminierter EL-Folie noch möglich ist. Schließlich ist die Wandstärke so gewählt, das der erfindungsgemäß angegebene Stecker montierbar ist. In diesem Sinn bevorzugt ist, wenn die erste und/oder zweite Kunststoffplatte aus Material aus der Familie der Polyester der Terephthalsäuren, insbesondere PET (Polyethylenterephthalat) oder PETG (Polyethylenterphthalat, Glycol-modifiziert) oder aus der Familie der Polyacryl- und methacrylpolymere, insbesondere PMMA (Polymethylmethacrylat) bestehen.

Beispielsweise ist für eine Schraubverbindung eine ausrechende Wandstärke notwendig, damit das Gewinde greifen kann, ohne dass das Gewindeloch bzw. die Schraube in die darunter liegende EL-Folie eindringt.

Vorzugsweise besteht zur besonderen optischen Wirkung das Objekt mit der EL-Lampe im Wesentlichen oder vollständig aus den Kunststoffplatten mit dazwischen einlaminierter EL-Folie. Darunter wird verstanden, dass sämtliche für den Betrachter maßgebliche Flächen des Objekts leuchten, wobei aus technischen Gründen ein schmaler nicht leuchtender Rand im Bereich der Ecken und Kanten verbleiben kann.

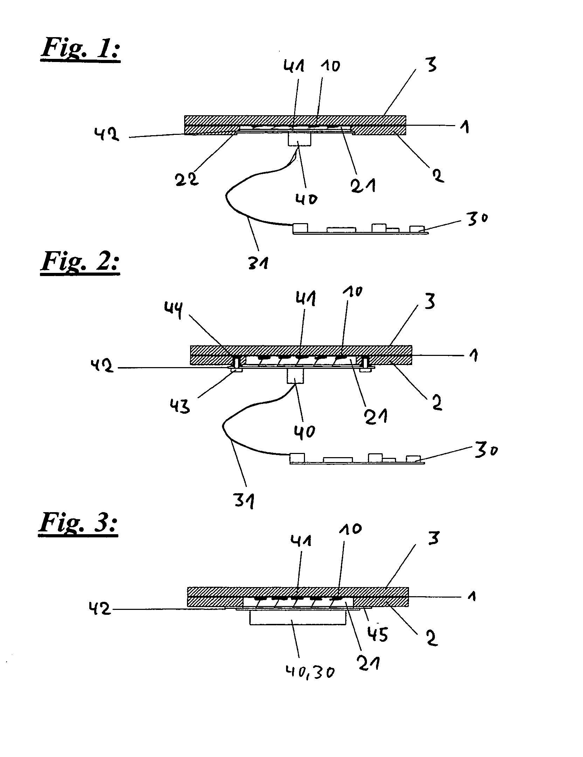

Im Folgenden wir die Erfindung anhand von Skizzen erläutert, wobei die Figuren 1 bis 5 unterschiedliche Kontaktierungsmöglichkeiten darstellen.
**Figuren 1 bis 5** zeigen alle gemeinsam eine zwischen einer ersten Kunststoffplatte 2 und zweiten Kunststoffplatte 3 einlaminierte EL-Folie, die nach oben, das heißt durch die obere Kunststoffplatte 3 Licht abstrahlt. Durch die in der unteren bzw. ersten Kunststoffplatte 2 gebildete Ausnehmung 21 liegt die Unterseite der EL-Folie 1 frei, wobei die darauf aufgebrachten elektrischen Kontaktflächen 10 von unten her zugänglich und kontaktierbar sind. Im konkreten Ausführungsbeispiel sind dabei fünf Kontaktflächen 10 zu erkennen, die beispielsweise zur Ansteuerung einer Vier-Segmet-EL-Folie dienen können, wobei eine Kontaktfläche die gemeinsame Masse für alle Segmente darstellt und die vier verbleibenden Kontaktflächen den vier Segmenten zugeordnet sind. Segment im Sinn der Erfmdung kann sowohl die räumliche Aufteilung der EL-Folie betreffen, als auch unterschiedliche Schichten, beispielsweise Schichten unterschiedlicher Farbe. In die untere Ausnehmung 21 ist zur Herstellung des elektrischen Kontaktes ein Stecker 40 eingebracht. Der Stecker 40, weist im Wesentlichen einen Kontaktbereich 42, z. B. hier einen leiterbahnähnlichen Träger zum elektrisch leitenden und mechanischem Befestigen der darauf angeordneten Federkontakte 41 auf. Die weitere Ausgestaltung und Befestigung des Steckers unterscheidet sich in den Figuren 1 bis 5, also insbesondere der Befestigungsbereich 42.

**Figur. 1** zeigt den Stecker mit einem Sockel zum Herausführen des Kabels 31 zur separat angeordneten Elektronik 30. Diese umfasst regelmäßig einen Spannungswandler Inverter und ggf. eine Ansteuerungselektronik zur Erzeugung besonderer Lichteffekte, beispielsweise bei Mehrsegmentlampen oder farbigen Lampen. Die Kontaktmittel sind in Form des Steckers 40 mit randseitigem Befestigungsbereich 42 zum Befestigen des Steckers an oder in der Ausnehmung der Kunststoffplatte versehen. Die Befestigung des Steckers 41 erfolgt hier im Inneren der Ausnehmung 21, wobei in der Ausnehmung 21 randseitige Abstufungen oder Hinterschneidungen 22 zum Einrasten der Außenkanten des Befestigungsteils 42 vorgesehen sind.

**Figur 2** zeigt im Wesentlichen den Stecker aus Figur 1 mit getrennter Ansteuerung 30. Abweichend davon ist jedoch der Befestigungsbereich 42 nicht in der Ausnehmung 21, sondern auf der die Ausnehmung 21 umgebenden Fläche mittels Schrauben in der unteren Kunststoffplatte 2 befestigt.

Durch die Schrauben wird der Stecker entgegen der Federkraft der Federkontakte 41 gegen die EL-Folie bzw. die untere Kunststoffplatte 2 gedrückt. Die entsprechenden Gewindelöcher in der unteren Kunststoffplatte 2 durchdringen nicht die untere Kunststoffplatte 2 vollständig bzw.
durchdringen keinesfalls die EL-Folie 1. Vorzugsweise werden die Gewindelöcher durch Gewindehülsen 44, welche in der unteren Kunststoffplatte eingepresst oder eingeklebt sind, gebildet.

**Figur 3** zeigt einen kompakten Stecker 40 mit integrierter Ansteuerung. Wie bei Figur 2 erfolgt die Befestigung des Befestigungsbereichs 42, auf der die Ausnehmung 21 umgebenden Fläche der unteren Kunststoffplatte 2 nicht durch Verschraubung, sondern durch Verklebung des Randbereichs. Diese Lösung ist besonders serientauglich und einfach durchzuführen, insbesondere da es nicht auf eine lösbare Verbindung des Steckers 30 mit der unteren Kunststoffplatte 2 ankommt. Es wird ausdrücklich festgestellt, dass die hier vorgeschlagene Lösung in Bezug auf den Stecker [kompakt oder mit separater Ansteuerung] vollkommen unabhängig von den vorgeschlagenen Befestigungsmöglichkeiten [in Ausnehmung eingeklemmt, aufgeschraubt oder aufgeklebt] ist.

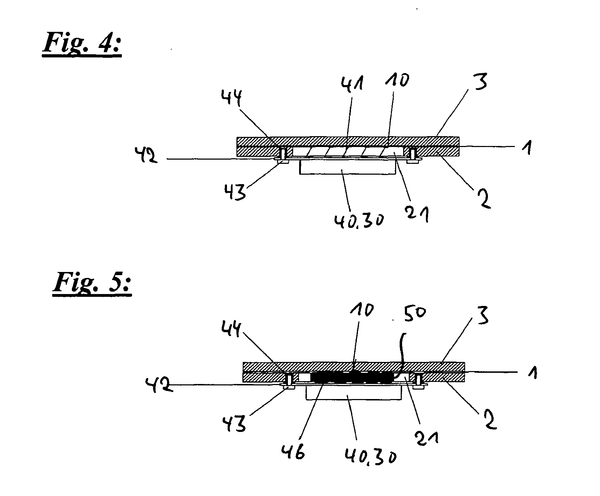

**Figur 4** zeigt die Befestigung eines Steckers aus Figur 3 mittels Befestigungsmittel wie in Figur 2.

**Figur 5** zeigt schließlich eine Lösung für - in der Figur nicht maßstabsgerecht gezeigte - geringe Abstände zwischen Stecker 40 und Kontaktflächen 10. Es handelt sich dabei um eine Alternative zu den Federkontakten 41. Steckerseitig sind untere Kontaktflächen 46 vorgesehen, die mit den gegenüberliegenden zueinander gewandten oberen Kontaktflächen 10 der EL-Folie elektrisch leitend zu verbinden sind. Dieser Abstand kann nun durch spezielle elastische und lediglich in vertikaler Richtung leitfähiger Polster 50, beispielsweise Zebra Stripes überbrückt werden. Wegen der derzeitig beschränkten Bauhöhe derartiger Pads ist die Anwendung jedoch auf Sonderfälle mit dünner unterer Kunststoffplatte 2 oder geringem Abstand zwischen den Kontaktflächen beschränkt.

Im Folgenden wird beispielartig ein Weg aufgezeigt, wie die Kontakte 10 der EL-Folie nach dem Laminieren mit der unteren bzw. ersten Kunststoffplatte 2 hergestellt werden können. Es stellt sich dabei das Problem, dass die Ausnehmung 21 genau bis auf die extrem dünnen Kontaktflächen 10 der EL-Folie reichen müssen. Diese Genauigkeit lässt sich beim Fräsen nicht erzeugen, d. h. entweder wird die Kontaktfläche 10 nicht freigelegt oder zerstört. Zu diesem Zweck wird vorgeschlagen, vor dem Laminieren die Kontaktflächen 10 mit elektrisch leitfähigen Puffern zu versehen, beispielsweise Kupferhütchen oder dergleichen. Beim Ausfräsen der Ausnehmung 21 besteht dann die Möglichkeit, dass der Fräser das leitfähige Material berühren und Anfräsen kann, ohne die Kontaktfläche zu zerstören. Es kann dann mittels der Federkontakte die Verbindung zu den Hütchen hergestellt werden. In einer alternativen Ausgestaltung besteht der Platzhalter aus einem ausreichend elastischem Material, zum Beispiel Heißkleber, welches beim Ausfräsen der Ausnehmung 21 freigelegt wird und herausgezogen werden kann. Vorteilhafterweise kann dabei dieser elastische Platzhalter in einem Stück über eine Vielzahl von Kontaktflächen 10 der EL-Folie arbeitssparend aufgebracht werden. Wesentlich ist dabei, dass es sich dabei um ein im gewünschten Arbeitsbereich ausreichend elastisches Material handelt, welches bei dem für das Laminieren typischen Temperaturen keine feste Verbindung mit den Kontaktflächen eingeht, also leicht zu entfernen ist. Als elastischer Platzhalter ist Silikon besonderes geeignet, da es ausreichend temperaturfest ist, sich nicht mit den Kunststoffplatten verbindet, gut mittels Pinzette greifbar ist und gut aus Öffnungen und sogar Hinterschneidungen herausziehbar ist. Gegebenenfalls ist ein geeignetes Trennmittel zwischen Kontaktflächen und Platzhalter einzusetzen.

## Patentansprüche

1. Elektrolumineszenz-Lampe mit
- einer zwischen einer ersten und einer zweiten transluzenten oder klarsichtigen Kunststoffplatte (3,2) einlaminierten EL-Folie (1), wobei die EL Folie mehrere elektrisch leitfähige nicht mit einer isolierenden Schicht versehene Kontaktflächen (10) aufweist, die sich in der Ebene der EL-Folie erstrecken und die senkrecht zur Ebene der EL Folie kontaktierbar sind und
- einem Kontaktmittel (40) mit Federkontakten (41) zur elektrischen Verbindung der Kontaktflächen (10) mit einer Spannungsversorgung (30),
**dadurch gekennzeichnet, dass** die Kontaktflächen (10) und die Federkontakte (41) innerhalb des Bereichs der Kunststoffplatten (2,3) angeordnet sind und insbesondere die Kontaktflächen nicht seitlich zwischen den Kunststoffplatten herausgeführt sind.

2. Lampe nach Anspruch 1, **dadurch gekennzeichnet, dass** in der ersten Kunststoffplatte (2) eine Ausnehmung (21) derart vorgesehen ist, dass die Kontaktflächen (10) frei liegen und mit den Federkontakten (40) elektrisch leitend verbunden sind, und in der ersten Kunststoffplatte (2) Befestigungsmittel (22,43,44,45) zum Befestigen der Kontaktmittel (40) mit dieser vorgesehen sind.

3. Lampe nach einem der vorherigen Ansprüche, **dadurch gekennzeichnet, dass** eine Vielzahl von Kontaktflächen (10) vorgesehen sind, die in einer gemeinsamen Ausnehmung (21) frei liegen.

4. Lampe nach einem der vorherigen Ansprüche, **dadurch gekennzeichnet, dass** die EL-Folie als Mehrsegmentfolie mit einer Vielzahl von Kontaktflächen (10) ausgebildet ist.

5. Lampe nach einem der vorherigen Ansprüche, **dadurch gekennzeichnet, dass** die Kontaktflächen nur auf einer Seite der EL-Folie vorgesehen sind.

6. Lampe nach einem der vorherigen Ansprüche, **dadurch gekennzeichnet, dass** die Kontaktmittel (40) als kompakter Stecker ausgebildet sind mit einem Kontaktbereich mit den Federkontakten, welche in Richtung auf die Kontaktflächen federnd wirken und mit einem Befestigungsbereich (42) zum Befestigen des Stecker an der ersten Kunststoffplatte.

7. Lampe nach einem der vorherigen Ansprüche, **dadurch gekennzeichnet, dass** der Stecker (40) über ein Kabel (31) mit der Stromversorgung (30) und/oder der Ansteuerung verbunden ist.

8. Lampe nach einem der vorherigen Ansprüche, **dadurch gekennzeichnet, dass** der Stecker die Stromversorgung und/oder der Ansteuerung aufweist.

9. Lampe nach einem der vorherigen Ansprüche, **dadurch gekennzeichnet, dass** der Befestigungsbereich (42) des Steckers auf der die Ausnehmung (21) umgebene Fläche der ersten Kunststoffplatte (2) parallel zu dieser aufliegt, wobei der Befestigungsbereich über Verbindungsmittel (44, 43 ,45) in der die Ausnehmung umgebenen Fläche der ersten Kunststoffplatte befestigt ist.

10. Lampe nach einem der vorherigen Ansprüche, **dadurch gekennzeichnet, dass** Schrauben (43) als Verbindungsmittel vorgesehen sind, die in entsprechend geformte Gewindelöcher (44) in der die Ausnehmung umgebenen Fläche der ersten Kunststoffplatte eingeschraubt sind, wobei vorzugsweise die Gewindelöcher als Sackloch ausgebildet sind.

11. Lampe nach einem der vorherigen Ansprüche, **dadurch gekennzeichnet, dass** die Seitenwände (22) der Ausnehmung (21) und der Befestigungsbereich (43) des Steckers derart ausgebildet sind, dass der Befestigungsbereich in der Ausnehmung befestigt ist.

12. Lampe nach einem der vorherigen Ansprüche, **dadurch gekennzeichnet, dass** die erste und vorzugsweise die zweite Kunststoffplatten eine Wandstärke von mindestens 0,5 mm, vorzugsweise mindestens 2 mm, insbesondere vorzugsweise mindestens 5 mm und ferner vorzugsweise mindestens 10 mm aufweisen.

13. Lampe nach einem der vorherigen Ansprüche, **dadurch gekennzeichnet, dass** das Objekts im Wesentlichen oder vollständig durch die Kunststoffplatten mit der dazwischen einlaminierten EL-Folie gebildet wird.

14. Lampe nach einem der vorherigen Ansprüche, **dadurch gekennzeichnet, dass** die erste und/oder zweite Kunststoffplatte aus Material aus der Familie der Polyester der Terephthalsäuren, insbesondere PET (Polyethylenterephthalat) oder PETG (Polyethylenterphthalat, Glycol-modifiziert) oder aus der Familie der Polyacryl- und methacrylpolymere, insbesondere PMMA (polymethylmethacrylat), bestehen.

15. Lampe nach einem der vorherigen Ansprüche, **dadurch gekennzeichnet, dass** die Verbindungsmittel auf Ausnehmung auf der Innenseite oder an für den Betrachter verdeckter Stelle vorgesehen ist.
